# EUROPÄISCHE PATENTSCHRIFT

(11) **EP 3 851 276 B1**
(45) Veröffentlichungstag und Bekanntmachung des Hinweises auf die Patenterteilung: **02.10.2024**
(21) Anmeldenummer: 20200108.7
(22) Anmeldetag: 05.10.2020
(51) Int. Cl.: B41F 15/08, B41F 15/20, B41F 15/26, B41F 15/42, B41F 33/00, B41F 33/16, B41M 1/12, H05K 3/12

(54) **COMPUTERIMPLEMENTIERTES VERFAHREN ZUR STEUERUNG EINER SIEBDRUCKMASCHINE UND COMPUTERGESTEUERTE SIEBDRUCKMASCHINE**
COMPUTER-IMPLEMENTED METHOD FOR CONTROLLING A SCREEN PRINTING MACHINE AND COMPUTER-CONTROLLED SCREEN PRINTING MACHINE
PROCÉDÉ MISE EN OEUVRE PAR ORDINATEUR PERMETTANT DE COMMANDER UNE MACHINE D'IMPRESSION SÉRIGRAPHIQUE ET MACHINE D'IMPRESSION SÉRIGRAPHIQUE COMMANDÉE PAR ORDINATEUR

(30) Priorität: 14.01.2020 DE 102020100648
(43) Veröffentlichungstag der Anmeldung: 21.07.2021
(73) Patentinhaber: Lambotec GmbH, 56271 Kleinmaischeid (DE)
(72) Erfinder:
(74) Vertreter: Müller-Boré & Partner Patentanwälte PartG mbB

(56) Entgegenhaltungen:
- WO-A2-2012/164233
- DE-A1- 102016 113 432
- DE-A1- 102018 205 157
- DE-A1- 4 011 223
- DE-C2- 2 743 234
- US-A1- 2019 364 666
- US-B2- 6 609 458

## Beschreibung

### Technisches Gebiet

Die Erfindung betrifft ein computerimplementiertes Verfahren zur Steuerung einer Siebdruckmaschine sowie eine computergesteuerte Siebdruckmaschine zur Ausführung des Verfahrens.

### Stand der Technik

Bei bekannten Siebdruckmaschinen wird das Sieb aufgrund der Reibung zwischen der Rakel und dem Sieb in der Bewegungsrichtung der Rakel gedehnt. Dadurch ist auch das Druckbild gegenüber den vom Sieb vorgegebenen Soll-Maßen in der Bewegungsrichtung gedehnt und somit verzerrt. Das Ausmaß der Verzerrung hängt von einer Vielzahl teilweise schwer zu kontrollierender Parameter, beispielsweise dem Alter des Siebes, der Siebspannung, der Ausführung und dem Material des Siebgewebes (z.B. fein oder grob gewebtes Sieb), den Materialeigenschaften der Druckpaste, welche den Reibkoeffizient zwischen Rakel und Sieb in der Regel verringert, dem Anstellwinkel der Rakel, der Rakelbeschaffenheit und der Rakelanpresskraft, der Umgebungstemperatur und der Luftfeuchtigkeit, ab.

Dadurch können die Abmessungen des Druckbilds nicht präzise vorhergesagt werden, was insbesondere für funktionale Anwendungen, beispielsweise gedruckte Batterien, Bildschirme, Photovoltaikmodule oder Heizmodule, bei denen es auf eine präzise Positionierung und Dimensionierung der Komponenten ankommt, problematisch ist.

Die Patentanmeldung DE1561112A beschreibt ein Verfahren zum Ausgleich des Versatzes beim Siebdruck, bei dem der Siebrahmen oder die Druckunterlage durch eine gesteuerte Mechanik im Augenblick des Ansatzes der Rakel entgegen der Zugrichtung der Rakel um einen im Andruck festgestellten Versatz verschoben wird. Durch das Verfahren wird nur ein Versatz zwischen aufeinanderfolgenden Drucklagen mit entgegengesetzter Rakelrichtung kompensiert, nicht jedoch eine Verzerrung des Druckbildes während des Druckens.

Die Patentanmeldung DE2743234C2 beschreibt eine Siebdruckvorrichtung, bei der der Siebrahmen durch ein Hebelsystem während des Druckvorgangs kontinuierlich entgegen der Dehnungsrichtung des Siebs bewegt wird, um eine Verzerrung des Druckbildes zu reduzieren.

Die Patentanmeldung WO9116202A1 beschreibt ebenfalls eine Siebdruckmaschine, bei der das Sieb rein mechanisch während des Druckens verschoben wird, um eine Verzerrung des Druckbilds zu verringern.

Nachteilig an den vorgenannten Ansätzen ist, dass sie die Verzerrung aufgrund der begrenzten Genauigkeit der mechanischen Verschiebevorrichtungen nicht vollständig kompensieren können und außerdem den Aufbau der Siebdruckmaschine erheblich verkomplizieren.

In der Druckschrift US 6609458B2 werden ferner ein computerimplementieres Verfahren und eine damit gesteuerte Siebdruckmaschine beschrieben, wobei eine durch Siebdehnungen bedingte Abweichung zwischen Sieb und Substrat in einer Einstellungsphase, u.a. anhand einer Direktinspektion des bedruckten Substrats, durch die Regelung des Anpressdrucks der Rakel und/ oder der Rakelgeschwindigkeit kompensiert wird.

### Technische Aufgabe

Die Aufgabe der Erfindung ist es, ein einfach umzusetzendes Verfahren zur Steuerung einer Siebdruckmaschine und eine kostengünstige Siebdruckmaschine bereitzustellen, um funktionale Schichten effizient, zuverlässig und mit hoher Präzision zu drucken.

### Technische Lösung

Der Gegenstand der vorliegenden Erfindung stellt ein Verfahren gemäß Anspruch 1 bereit, das die technische Aufgabe löst. Ebenso wird die Aufgabe durch eine Siebdruckmaschine gemäß Anspruch 7 gelöst. Vorteilhafte Ausgestaltungen ergeben sich aus den abhängigen Ansprüchen.

### Beschreibung der Ausführungsarten

Die Erfindung betrifft ein computerimplementiertes Verfahren zur Steuerung einer Siebdruckmaschine mit zumindest einem Rakelantrieb zur Translation einer Rakel der Siebdruckmaschine relativ zu einem Sieb der Siebdruckmaschine zumindest entlang einer zu dem Sieb parallelen X-Achse, zumindest einem Plattenantrieb zur Verschiebung einer Druckplatte der Siebdruckmaschine zumindest entlang der X-Achse relativ zu dem Sieb und zumindest einem mit dem Rakelantrieb und dem Plattenantrieb kommunikativ verbundenen Computergerät.

Bei dem Rakelantrieb und dem Plattenantrieb handelt es sich um elektrische Antriebe, die von dem Computergerät gesteuert werden, so dass eine höhere notwendige Präzision und Reproduzierbarkeit als mit bei Siebdruckmaschinen üblicherweise verwendeten pneumatische oder manuellen Antrieben gewährleistet sind.

Das Verfahren umfasst den Schritt des Fixierens eines Substrats auf der Druckplatte. Durch das Fixieren wird vorteilhafterweise sichergestellt, dass sich das zu bedruckende Substrat nicht gegenüber der Druckplatte verschiebt, wodurch das Druckbild ebenfalls verschoben und/oder verzerrt werden könnte.

Das Verfahren umfasst den Schritt eines automatischen Druckens einer Druckpaste mit der Rakel durch das Sieb zur Erzeugung eines Druckbilds auf dem Substrat nach dem Fixieren, wobei das Computergerät die Rakel mit dem Rakelantrieb mit einer Rakelgeschwindigkeit entlang der X-Achse über das Sieb zieht.

Das Verfahren umfasst den Schritt eines Bestimmens zumindest einer Abweichung einer Ist-Abmessung des Druckbilds entlang der X-Achse von einer zugehörigen Soll-Abmessung des Druckbilds nach dem Drucken. Bei der Abweichung handelt es sich insbesondere um eine Verzerrung des Druckbilds durch eine Dehnung des Siebs während des Druckens.

Das Verfahren kann den Schritt eines Bestimmens mehrerer Abweichungen umfassen, beispielsweise um einer von einer Position entlang der X-Achse abhängigen Dehnung des Siebs Rechnung zu tragen. Die Dehnung kann beispielsweise abhängig von einer Entfernung zu einem das Sieb tragenden Siebrahmen oder abhängig von einer Dichte von Durchbrechungen des Siebs entlang der X-Achse variieren.

Das Verfahren umfasst den Schritt des Berechnens zumindest einer Plattengeschwindigkeit der Druckplatte zur Kompensation der Abweichung durch das Computergerät. Das Verfahren kann ein Berechnen von mehreren Plattengeschwindigkeiten, insbesondere eines Geschwindigkeitsprofils, beispielsweise abhängig von einer Position der Rakel entlang der X-Achse während des Druckens umfassen.

Das Verfahren umfasst den Schritt eines Verschiebens der Druckplatte mit dem Plattenantrieb mit der zumindest einen Plattengeschwindigkeit entlang der X-Achse durch das Computergerät.

Da das Bestimmen nach dem Drucken erfolgt, erfolgt das Verschieben bei einem weiteren Drucken. Somit wird ein Andruck auf einem Testsubstrat gedruckt, während das im Fortdruck zu bedruckende Substrat erst bei dem weiteren Drucken bedruckt wird.

Das Computergerät zieht die Rakel bei dem Drucken vorzugsweise mit zumindest einem Servomotor des Rakelantriebs über das Sieb. Das Computergerät verschiebt die Druckplatte bei dem Verschieben vorzugsweise mit zumindest einem Servomotor des Plattenantriebs. Durch Servomotoren ist eine besonders genaue und reproduzierbare Translation der Rakel und der Druckplatte möglich, insbesondere kann die Verschiebung der Druckplatte durch das Computergerät in Abhängigkeit von der Translation der Rakel, beispielsweise in einem Master-Slave-Verfahren, gesteuert werden.

Das Computergerät misst bevorzugt eine Geschwindigkeit zumindest eines der Servomotoren mit einem Absolutwertgeber des Servomotors. Dadurch kann das Computergerät die Geschwindigkeit in einem geschlossenen Regelkreis besonders präzise und reproduzierbar regeln.

Der Absolutwertgeber stellt besonders bevorzugt eine Ortsauflösung einer Rakelposition der Rakel oder einer Plattenposition der Druckplatte entlang der X-Achse von 0,1 µm bis 100 µm, besonders bevorzugt von 1 µm bis 10 µm, beispielsweise 4 µm, bereit. Eine hohe Auflösung, die zum Drucken klassischer Druckerzeugnisse nicht notwendig ist, erlaubt das Drucken funktionaler Schichten, beispielsweise gedruckter Schaltungen, mit einer hohen Integrationsdichte.

Das Fixieren des Substrats auf der Druckplatte umfasst vorzugsweise ein automatisches Ansaugen des Substrats an die Druckplatte mit einer von dem Computergerät gesteuerten Vakuum-Fixiervorrichtung der Druckplatte. Durch das Ansaugen lassen sich auch dünne und flexible Substrate, beispielsweise Folien, sicher und gleichmäßig auf der Druckplatte fixieren. Die Vakuum-Fixiervorrichtung kann beispielsweise so wie in der Patentanmeldung DE102011012870A1 beschrieben ausgestaltet sein.

Das Bestimmen der zumindest einen Abweichung der Ist-Abmessung des Druckbilds von der zugehörigen Soll-Abmessung umfasst erfindungsgemäß ein Ermitteln der Ist-Abmessung des Druckbilds entlang der X-Achse nach dem Drucken und ein Berechnen der Abweichung (Δx) als Differenz der Soll-Abmessung (xₛ) von der Ist-Abmessung (xᵢ), insbesondere durch das Computergerät: Δx = xᵢ - xₛ.

Nach dem Drucken ist das Ermitteln der Ist-Abmessung besonders einfach, weil das Substrat von dem Sieb entfernt werden kann, sodass das Druckbild leicht zugänglich ist.

Das Ermitteln der Ist-Abmessung Druckbilds erfolgt vorzugsweise an mehreren entlang der X-Achse voneinander beabstandeten Positionen des Druckbilds. Dadurch kann eine von der Position entlang der X-Achse abhängige Abweichung der Ist-Abmessung des Druckbilds von der zugehörigen Soll-Abmessung bestimmt werden. Aus der von der Position entlang der X-Achse abhängigen Abweichung kann eine von der Position entlang der X-Achse abhängige Plattengeschwindigkeit zur Kompensation einer der Abweichung berechnet werden. Auf diese Weise kann die Auswirkung einer entlang der X-Achse variablen Siebdehnung kompensiert werden.

Das Ermitteln der Ist-Abmessung Druckbilds erfolgt vorzugsweise an mehreren senkrecht zur X-Achse voneinander beabstandeten Positionen des Druckbilds. Daraus ergibt sich der Vorteil, dass eine mögliche Verscherung des Siebs durch eine senkrecht zur X-Achse variable Dehnung detektiert werden kann. Die Verscherung kann beispielsweise durch einen entlang der X-Achse variablen Anpressdruck der Rakel an das Sieb, beispielsweise durch einen nicht ordnungsgemäßen Einbau der Rakel, verursacht sein. Wenn das Computergerät eine Verscherung detektiert, kann es beispielsweise eine Fehlermeldung oder eine Warnmeldung an einen Benutzer der Siebdruckmaschine ausgeben.

Das Ermitteln der Ist-Abmessung Druckbilds erfolgt automatisch durch das Computergerät mit Hilfe eines kommunikativ mit dem Computergerät verbundenen Sensorsystems der Siebdruckmaschine erfolgt. Durch ein automatisches Ermitteln können eine besonders hohe Geschwindigkeit und Genauigkeit erzielt werden.

Das Sensorsystem kann beispielsweise zumindest einen abbildenden Laserscanner zur Abbildung zumindest eines Teils des Druckbilds umfassen.

Das Sensorsystem verwendet vorzugsweise ultraviolettes, sichtbares und/oder infrarotes Licht zum Ermitteln der Ist-Abmessung Druckbilds. Dadurch ist ein berührungsloses und präzises Ermitteln möglich, und zum Aufbau des Sensorsystems sind kostengünstige Komponenten verfügbar.

Das Ermitteln umfasst bevorzugt ein Anwenden eines Bilderkennungsalgorithmus auf ein mit einer Kamera des Sensorsystems aufgenommenes Bild des Druckbilds. Durch die Auswertung eines Bildes kann das automatische Ermitteln mit geringem Hardware-Aufwand erfolgen.

Das Bild weist besonders bevorzugt eine Ortsauflösung des Druckbilds entlang der X-Achse von 0,1 µm bis 100 µm, meist bevorzugt von 1 µm bis 10 µm, beispielsweise von 4 µm, auf. Eine hohe Auflösung, die zum Drucken klassischer Druckerzeugnisse nicht notwendig ist, erlaubt eine besonders genaue Kompensation der Siebdehnung, beispielsweise für das Drucken funktionaler Schichten, beispielsweise gedruckter Schaltungen, mit einer hohen Integrationsdichte.

Das Berechnen führt vorzugsweise zu einer Plattengeschwindigkeit, die zu der Rakelgeschwindigkeit gleichgerichtet ist, wenn die Abweichung positiv ist. Wenn die Abweichung positiv ist, ist das Druckbild entlang der X-Achse gegenüber seiner Soll-Abmessung gedehnt. Eine solche Dehnung kann kompensiert werden, indem die Druckplatte mit der Rakel gleichgerichtet verschoben wird. Entsprechend ist die Plattengeschwindigkeit vorzugsweise der Rakelgeschwindigkeit entgegengerichtet, wenn die Abweichung negativ, das Druckbild also entlang der X-Achse gegenüber seiner Soll-Abmessung gestaucht, ist.

Das Berechnen führt bevorzugt zu einer Plattengeschwindigkeit (v_{P}), die einem Produkt der Rakelgeschwindigkeit (v_{R}) mit der Abweichung (Δx) dividiert durch die Soll-Abmessung (xₛ) entspricht: v_{P} = v_{R} * Δx / xₛ. In diesem Fall entspricht das Verhältnis der Plattengeschwindigkeit zur Rakelgeschwindigkeit dem Verhältnis der Abweichung zur Soll-Abmessung. Versuche haben gezeigt, dass sich eine Verzerrung des Druckbilds durch eine solche Plattengeschwindigkeit weitgehend verhindern lässt.

Die Erfindung betrifft eine computergesteuerte Siebdruckmaschine, die zur Ausführung eines erfindungsgemäßen Verfahrens ausgestaltet ist. Die Siebdruckmaschine umfasst zumindest einen elektrischen Rakelantrieb zur Translation einer Rakel der Siebdruckmaschine relativ zu einem Sieb der Siebdruckmaschine zumindest entlang einer zu dem Sieb parallelen X-Achse, zumindest einen elektrischen Plattenantrieb zur Translation einer Druckplatte der Siebdruckmaschine zumindest entlang der X-Achse relativ zu dem Sieb und zumindest ein mit dem Rakelantrieb und dem Plattenantrieb kommunikativ verbundenes Computergerät.

Die Komponenten der Siebdruckmaschine können insbesondere so ausgestaltet sein wie zum erfindungsgemäßen Verfahren beschreiben, woraus sich die dort genannten Vorteile ergeben.

Der Rakelantrieb und/oder der Plattenantrieb umfasst vorzugsweise jeweils zumindest einen kommunikativ mit dem Computergerät verbundenen Servomotor.

Der zumindest einen Servomotor umfasst vorzugsweise zumindest einen kommunikativ mit dem Computergerät verbundenen Absolutwertgeber, wobei der Absolutwertgeber bevorzugt eine Ortsauflösung einer Rakelposition der Rakel oder einer Plattenposition der Druckplatte entlang der X-Achse von 0,1 µm bis 100 µm, besonders bevorzugt von 1 µm bis 10 µm, beispielsweise von 4 µm, bereitstellt.

Die Siebdruckmaschine umfasst ein kommunikativ mit dem Computergerät verbundenes Sensorsystem zum automatischen Ermitteln einer Ist-Abmessung eines mit der Siebdruckmaschine gedruckten Druckbilds entlang der X-Achse, wobei das Sensorsystem bevorzugt eine Kamera zur Aufnahme eines Bildes des Druckbilds, besonders bevorzugt mit einer Ortsauflösung entlang der X-Achse von 0,1 µm bis 100 µm, besonders bevorzugt von 1 µm bis 10 µm, beispielsweise von 4 µm, umfasst.

Die Druckplatte umfasst vorzugsweise eine kommunikativ mit dem Computergerät verbundene Vakuum-Fixiervorrichtung zum Ansaugen eines mit der Siebdruckmaschine zu bedruckenden Substrats an die Druckplatte.

### Kurze Beschreibung der Zeichnungen

Weitere Vorteile, Ziele und Eigenschaften der Erfindung werden anhand nachfolgender Beschreibung und anliegender Zeichnungen erläutert, in welchen beispielhaft erfindungsgemäße Gegenstände dargestellt sind. Merkmale, welche in den Figuren wenigstens im Wesentlichen hinsichtlich ihrer Funktion übereinstimmen, können hierbei mit gleichen Bezugszeichen gekennzeichnet sein, wobei diese Merkmale nicht in allen Figuren beziffert und erläutert sein müssen.
Figur 1 zeigt eine schematische, perspektivische Zeichnung einer erfindungsgemäßen Siebdruckmaschine.
Figur 2 zeigt eine schematische, perspektivische Zeichnung einer Druckplatte der Siebdruckmaschine aus Figur 1.
Figur 3 zeigt eine schematische Darstellung eines erfindungsgemäßen Verfahrens zur Steuerung einer Siebdruckmaschine.
Figur 4 zeigt eine schematische Darstellung eines weiteren, nicht mehr von den Ansprüchen gedeckten Verfahrens zur Steuerung einer Siebdruckmaschine.
Figur 5 zeigt eine schematische Aufsicht auf das Sieb einer Siebdruckmaschine 100 während eines Druckens.

### Fig.1

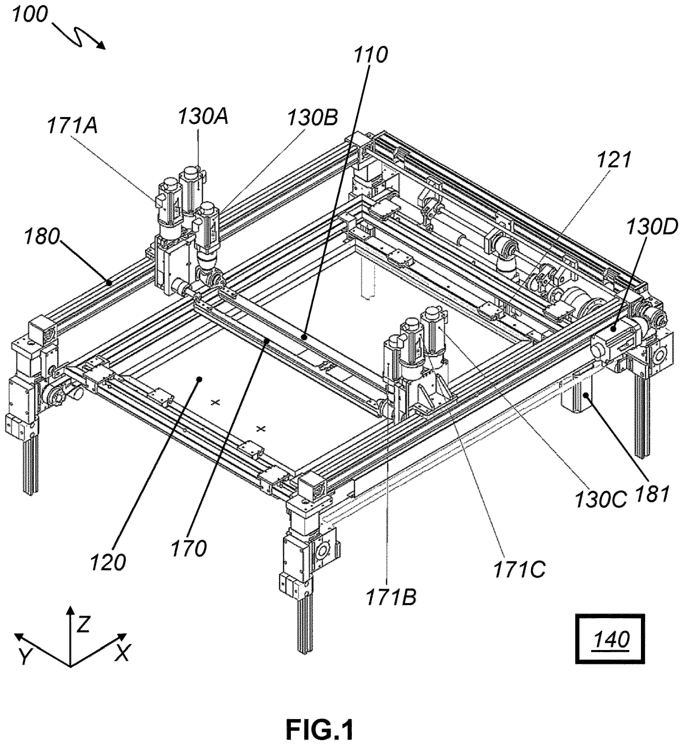

Figur 1 zeigt eine schematische, perspektivische Zeichnung einer erfindungsgemäßen Siebdruckmaschine 100 mit zumindest einem Sieb 120, zumindest einer Rakel 110, zumindest einem Rakelantrieb 130 zur Translation der Rakel 110 relativ zu dem Sieb 120 entlang einer zu dem Sieb 120 parallelen X-Achse und zumindest einem Computergerät 140 zur Steuerung der Siebdruckmaschine 100.

Dazu kann das Computergerät 140 kabellos oder kabelgebundenen mit den übrigen Komponenten der Siebdruckmaschine 100 kommunikativ verbunden sein. Der Übersichtlichkeit halber sind die kommunikativen Verbindungen nicht dargestellt.

Der Rakelantrieb 130 umfasst beispielsweise vier Elektromotoren 130A, 130B, 130C, 130D, insbesondere Servomotoren. Davon dienen beispielsweise zwei Elektromotoren 130A, 130C einer vertikalen Translation der Rakel 110 entlang der Z-Achse, ein weiterer Elektromotor 130B einer Rotation der Rakel 110 um die Y-Achse und ein weiterer Elektromotor 130D einer horizontalen Translation der Rakel 110, und vorzugsweise auch einer Flutrakel 170 der Siebdruckmaschine 100, entlang der X-Achse.

Die Siebdruckmaschine 100 umfasst vorzugsweise einen mit dem Computergerät 140 kommunikativ verbundenen Siebantrieb 121 zur Translation des Siebs 120 entlang der Z-Achse relativ zu dem Substrat

Die Siebdruckmaschine 100 umfasst vorzugsweise eine Flutrakel 170 zur Verteilung der Druckpaste auf dem Sieb 120 und einen mit dem Computergerät 140 kommunikativ verbundenen Flutrakelantrieb 171 zur Translation der Flutrakel 170 relativ zu dem Sieb 120 entlang der X-Achse und entlang der Z-Achse sowie zur Rotation der Flutrakel 170 relativ zu dem Sieb 120 um die Y-Achse.

Der Flutrakelantrieb 171 umfasst beispielsweise drei Elektromotoren 171A, 171B, 171C. Davon dienen beispielsweise 2 Elektromotoren 171A, 171C einer vertikalen Translation der Flutrakel 170 entlang der Z-Achsel und ein weiterer Elektromotor 171B einer Rotation der Flutrakel 170 um die Y-Achse.

Die Siebdruckmaschine 100 umfasst vorzugsweise einen die zumindest eine Rakel 110 und die zumindest eine Flutrakel 170 tragenden Rahmen 180 und einen mit dem Computergerät 140 kommunikativ verbundenen Rahmenantrieb 181 zur Translation des Rahmens 180 relativ zu dem Sieb 120 entlang der Z-Achse.

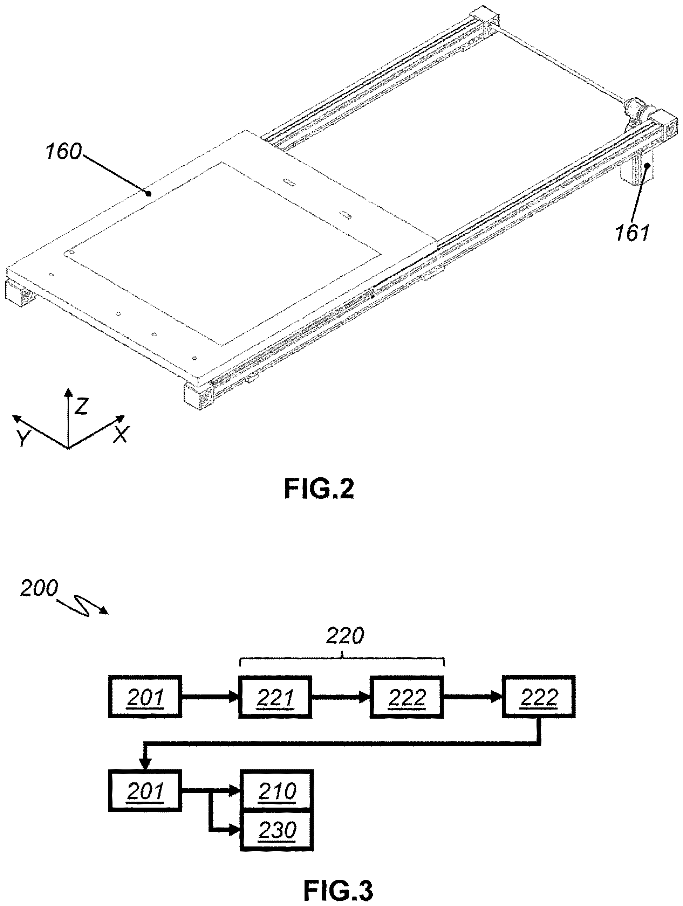

Die Siebdruckmaschine 100 umfasst ferner eine Druckplatte zur Aufnahme des zu bedruckenden Substrats, die der Übersichtlichkeit halber separat in Figur 2 gezeigt ist.

### Fig.2

Figur 2 zeigt eine schematische, perspektivische Zeichnung einer Druckplatte 160 der Siebdruckmaschine 100 aus Figur 1. Die Siebdruckmaschine 100 umfasst einen mit dem Computergerät 140 kommunikativ verbundenen Druckplattenantrieb 161, beispielsweise mit zumindest einem Servomotor, zur Translation der Druckplatte 160 entlang der X-Achse relativ zu dem Sieb 120.

### Fig.3

Figur 3 zeigt eine schematische Darstellung eines erfindungsgemäßen Verfahrens 200 zur Steuerung einer, insbesondere erfindungsgemäßen, Siebdruckmaschine 100. Das Verfahren 200 umfasst den Schritt eines Fixierens 201 eines Substrats auf der Druckplatte 160 der Siebdruckmaschine 100, beispielsweise durch ein Ansaugen des Substrats mit Hilfe eine Vakuum-Fixiervorrichtung.

Das Verfahren 200 umfasst den Schritt eines automatisierten Druckens 210 einer Druckpaste mit der Rakel 110 der Siebdruckmaschine 100 durch das Sieb 120 der Siebdruckmaschine 100 zur Erzeugung eines Druckbilds auf dem Substrat nach dem Fixieren 201, wobei das Computergerät 140 der Siebdruckmaschine 100 die Rakel 110 mit dem Rakelantrieb 130 der Siebdruckmaschine 100 mit einer Rakelgeschwindigkeit entlang der X-Achse über das Sieb 120 zieht

Das Verfahren 200 umfasst, nach dem Drucken 210, den Schritt eines Bestimmens 220 einer Abweichung einer Ist-Abmessung des Druckbilds entlang der X-Achse von einer zugehörigen Soll-Abmessung des Druckbilds. Das Bestimmen 220 umfasst den Schritt eines Ermittelns 221 der Ist-Abmessung des Druckbilds entlang der X-Achse nach dem Drucken 210 und den Schritt eines Berechnes 222 der Abweichung als Differenz der Soll-Abmessung von der Ist-Abmessung.

Das Verfahren 200 umfasst den Schritt eines Berechnens 222 einer Plattengeschwindigkeit der Druckplatte 160 zur Kompensation der Abweichung durch das Computergerät 140.

Das Verfahren 200 umfasst einen Schritt des Verschiebens 230 der Druckplatte 160 mit dem Plattenantrieb 161 mit der Plattengeschwindigkeit entlang der X-Achse durch das Computergerät 140.

Das Verschieben 230 erfolgt während eines weiteren Druckens 210 nachdem das Substrat durch ein weiteres Substrat ersetzt wurde und ein Fixieren 201 des weiteren Substrats auf der Druckplatte 160 erfolgt ist.

### Fig.4

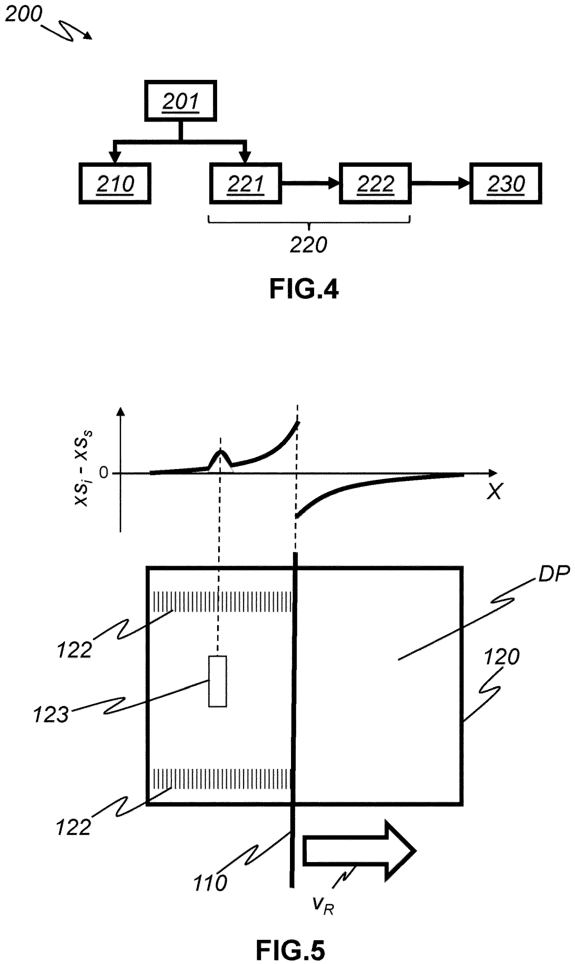

Figur 4 zeigt eine schematische Darstellung eines weiteren, nicht mehr von den Ansprüchen gedeckten Verfahrens 200 zur Steuerung der Siebdruckmaschine 100.

Das Verfahren 200 unterscheidet sich von dem in Figur 3 dargestellten Verfahren 200 darin, dass das Bestimmen 220 der Abweichung der Ist-Abmessung des Druckbilds von der zugehörigen Soll-Abmessung während des Druckens 210 stattfindet.

Das Bestimmen 220 umfasst beispielsweise den Schritt eines Ermittelns 221 zumindest einer Ist-Siebabmessung des Siebs 160 entlang der X-Achse hinter der Rakel 110 bezogen auf eine Bewegungsrichtung der Rakel 110 während des Druckens 210 und den Schritt eines Berechnens 222 der Abweichung aus einer Differenz einer zugehörigen Soll-Siebabmessung des Siebs 160 von der Ist-Siebabmessung.

Dadurch kann vorteilhafterweise auch das Verschieben 230 der Druckplatte 160 während des Druckens 210 erfolgen, ohne dass ein separater Andruck notwendig ist.

### Fig.5

Figur 5 zeigt eine schematische Aufsicht auf das Sieb 120 der Siebdruckmaschine 100 während eines Druckens 210, gemäß dem obigen, nicht mehr von den Ansprüchen gedeckten Verfahren 200.

Während des Druckens 210 wird eine Rakel 110 in einer Bewegungsrichtung mit einer Rakelgeschwindigkeit v_{R} entlang einer X-Achse über das Sieb 120 gezogen

Die sichtbare Oberseite des Siebs 120 ist in Bewegungsrichtung vor der Rakel 120 von einer Druckpaste DP bedeckt und in Bewegungsrichtung hinter der Rakel 120 im Wesentlichen frei von Druckpaste DP.

In Figur 5 ist außerdem ein schematischer Verlauf einer Differenz xsᵢ - xsₛ einer Soll-Siebabmessung xsₛ des Siebs 160 entlang der X-Achse von einer zugehörigen Ist-Siebabmessung xsᵢ abhängig von einer Position entlang der X-Achse aufgetragen

Hinter einer momentanen Position der Rakel 110 entlang der X-Achse ist das Sieb 120 gedehnt, sodass die Differenz xsᵢ - xsₛ positiv ist. Vor der momentanen Position der Rakel 110 entlang der X-Achse ist das Sieb 120 gestaucht, sodass die Differenz xsᵢ - xsₛ negativ ist. Der Betrag der Differenz xsᵢ - xsₛ nimmt jeweils von der momentanen Position der Rakel 110 zu den Rändern des Siebs 120 ab.

Im einfachsten Fall nimmt der Betrag der Differenz xsᵢ - xsₛ monoton ab, er kann aber auch lokale Extrema aufweisen, beispielsweise wenn das Sieb 120 in einem Bereich einer Durchbrechung 123 des Siebs 120 stärker gedehnt wird als außerhalb des Bereichs.

In einem solchen Bereich stärkerer Dehnung ist auch eine Abweichung einer Ist-Abmessung des Druckbilds entlang der X-Achse von einer zugehörigen Soll-Abmessung höher als außerhalb des Bereichs, sodass in dem Bereich eine höhere Plattengeschwindigkeit zur Kompensation der Abweichung notwendig ist als außerhalb des Bereichs.

Das Sieb 160 umfasst beispielsweise zumindest ein Muster 122 zum Ermitteln 221 der zumindest einen Ist-Siebabmessung xsᵢ. Das zumindest eine Muster 122 umfasst beispielsweise eine Vielzahl von entlang der X-Achse voneinander beabstandeten und senkrecht zur X-Achse ausgerichteten Linien, die bevorzugt durch ein Kamerasystem der Siebdruckmaschine erfassbar sind.

Das Sieb 160 kann mehrere, beispielsweise zwei, senkrecht zur X-Achse voneinander beabstandete Muster 122 umfassen. Daraus ergibt sich der Vorteil, dass eine mögliche Verscherung des Siebs durch eine senkrecht zur X-Achse variable Dehnung detektiert werden kann.

**Liste der Bezugszeichen**

| | | | |
|---|---|---|---|
| 100 | Siebdruckmaschine | 210 | Drucken |
| 110 | Rakel | 220 | Bestimmen |
| 120 | Sieb | 221 | Ermitteln |
| 121 | Siebantrieb | 222 | Berechnen |
| 122 | Muster | 230 | Verschieben |
| 123 | Durchbrechung | DP | Druckpaste |
| 130 | Rakelantrieb | v_{P} | Plattengeschwindigkeit |
| 140 | Computergerät | v_{R} | Rakelgeschwindigkeit |
| 150 | Sensorsystem | xsᵢ | Ist-Abmessung |
| 160 | Druckplatte | xsₛ | Soll-Abmessung |
| 161 | Plattenantrieb | Δx | Abweichung |
| 170 | Flutrakel | xsᵢ | Ist-Siebabmessung |
| 171 | Flutrakelantrieb | xsₛ | Soll-Siebabmessung |
| 180 | Rahmen | X | X-Achse |
| 181 | Rahmenantrieb | Y | Y-Achse |
| 200 | Verfahren | Z | Z-Achse |
| 201 | Fixieren | | |

## Patentansprüche

1. Computerimplementiertes Verfahren (200) zur Steuerung einer Siebdruckmaschine (100) mit
a) zumindest einem elektrischen Rakelantrieb (130) zur Translation einer Rakel (110) der Siebdruckmaschine (100) relativ zu einem Sieb (120) der Siebdruckmaschine (100) zumindest entlang einer zu dem Sieb (120) parallelen X-Achse (X),
b) zumindest einem elektrischen Plattenantrieb (161) zur Verschiebung einer Druckplatte (160) der Siebdruckmaschine (100) zumindest entlang der X-Achse (X) relativ zu dem Sieb (120) und
c) zumindest einem mit dem Rakelantrieb (130) und dem Plattenantrieb (161) kommunikativ verbundenen Computergerät (140),
**umfassend folgende Schritte:**
d) Fixieren (201) eines Substrats auf der Druckplatte (160),
e) automatisiertes Drucken (210) einer Druckpaste (DP) mit der Rakel (110) durch das Sieb (120) zur Erzeugung eines Druckbilds auf dem Substrat nach dem Fixieren (201),
e1) wobei das Computergerät (140) die Rakel (110) mit dem Rakelantrieb (130) mit einer Rakelgeschwindigkeit (v_{R}) entlang der X-Achse (X) über das Sieb (120) zieht,
f) Entfernen des Substrats von dem Sieb (120) nach dem Drucken (210),
g) Bestimmen (220) zumindest einer Abweichung (Δx) einer Ist-Abmessung (xᵢ) des Druckbilds entlang der X-Achse (X) von einer zugehörigen Soll-Abmessung (xₛ) des Druckbilds nach dem Drucken (210) und nach dem Entfernen des Substrats von dem Sieb (120),
h) Berechnen (222) zumindest einer Plattengeschwindigkeit (v_{P}) der Druckplatte (160) zur Kompensation der Abweichung (Δx) durch das Computergerät (140) und
i) Verschieben (230) der Druckplatte (160) mit dem Plattenantrieb (161) mit der zumindest einen Plattengeschwindigkeit (v_{P}) entlang der X-Achse (X) durch das Computergerät (140) während eines weiteren Druckens (210),
j) wobei das Bestimmen (220) der Abweichung (Δx) der Ist-Abmessung (xᵢ) des Druckbilds von der zugehörigen Soll-Abmessung (xₛ) folgende Schritte umfasst:
j1) Ermitteln (221) der Ist-Abmessung (xᵢ) des Druckbilds entlang der X-Achse (X) automatisch durch das Computergerät (140) mit Hilfe eines kommunikativ mit dem Computergerät (140) verbundenen Sensorsystems (150) der Siebdruckmaschine (100) nach dem Drucken (210) und
j2) Berechnen (222) der Abweichung (Δx) als Differenz (xᵢ - xₛ) der Soll-Abmessung (xₛ) von der Ist-Abmessung (xᵢ).

2. Verfahren nach Anspruch 1,
**dadurch gekennzeichnet, dass**
a) das Computergerät (140) die Rakel (110) bei dem Drucken (210) mit zumindest einem Servomotor des Rakelantriebs (130) über das Sieb (120) zieht, und
b) das Computergerät (140) die Druckplatte (160) bei dem Verschieben (230) mit zumindest einem Servomotor des Plattenantriebs (161) verschiebt,
c) wobei das Computergerät (140) bevorzugt eine Geschwindigkeit zumindest eines der Servomotoren mit einem Absolutwertgeber des Servomotors misst,
d) wobei der Absolutwertgeber besonders bevorzugt eine Ortsauflösung einer Rakelposition der Rakel (110) oder einer Plattenposition der Druckplatte (160) entlang der X-Achse (X) von 0,1 µm bis 100 µm, besonders bevorzugt von 1 µm bis 10 µm, bereitstellt.

3. Verfahren nach einem der Ansprüche 1 bis 2,
**dadurch gekennzeichnet, dass**
das Fixieren (201) des Substrats auf der Druckplatte (160) ein automatisches Ansaugen des Substrats an die Druckplatte (160) mit einer von dem Computergerät (140) gesteuerten Vakuum-Fixiervorrichtung (162) der Druckplatte (160) umfasst.

4. Verfahren nach Anspruch einem der Ansprüche 1 bis 3,
**dadurch gekennzeichnet, dass**
a) das Ermitteln (221) der Ist-Abmessung (xᵢ) des Druckbilds entlang der X-Achse an mehreren entlang der X-Achse voneinander beabstandeten Positionen des Druckbilds erfolgt,
b) wobei das Berechnen (222) der Abweichung (Δx) zu einer von einer Position entlang der X-Achse abhängigen Abweichung (Δx) führt,
c) wobei das Berechnen (222) der Plattengeschwindigkeit (v_{P}) zu einer von der Position entlang der X-Achse abhängigen Plattengeschwindigkeit (v_{P}) führt.

5. Verfahren nach einem der Ansprüche 1 bis 4,
**dadurch gekennzeichnet, dass**
a) wobei das Ermitteln (221) bevorzugt ein Anwenden eines Bilderkennungsalgorithmus auf ein mit einer Kamera (151) des Sensorsystems (150) aufgenommenes Bild des Druckbilds umfasst,
b) wobei das Bild besonders bevorzugt eine Ortsauflösung des Druckbilds entlang der X-Achse (X) von 0,1 µm bis 100 µm, meist bevorzugt von 1 µm bis 10 µm, aufweist.

6. Verfahren nach einem der Ansprüche 1 bis 5,
**dadurch gekennzeichnet, dass**
a) das Berechnen (222) zu einer Plattengeschwindigkeit (v_{P}) führt, die zu der Rakelgeschwindigkeit (v_{R}) gleichgerichtet ist, wenn die Abweichung (Δx) positiv ist, wobei
b) das Berechnen (222) bevorzugt zu einer Plattengeschwindigkeit (v_{P}) führt, die einem Produkt der Rakelgeschwindigkeit (v_{R}) mit der Abweichung (Δx) dividiert durch die Soll-Abmessung (xₛ) entspricht.

7. Computergesteuerte Siebdruckmaschine (100) zur Ausführung eines Verfahrens nach einem der Ansprüche 1 bis 6, umfassend
a) zumindest einen elektrischen Rakelantrieb (130) zur Translation einer Rakel (110) der Siebdruckmaschine (100) relativ zu einem Sieb (120) der Siebdruckmaschine (100) zumindest entlang einer zu dem Sieb (120) parallelen X-Achse (X),
b) zumindest einen elektrischen Plattenantrieb (161) zur Translation einer Druckplatte (160) der Siebdruckmaschine (100) zumindest entlang der X-Achse (X) relativ zu dem Sieb (120) und
c) zumindest ein mit dem Rakelantrieb (130) und dem Plattenantrieb (161) kommunikativ verbundenes Computergerät (140) und
d) ein kommunikativ mit dem Computergerät (140) verbundenes Sensorsystem (150) zum automatischen Ermitteln (221) einer Ist-Abmessung (xᵢ) eines mit der Siebdruckmaschine (100) gedruckten Druckbilds entlang der X-Achse (X),
e) wobei der Rakelantrieb (130) und der Plattenantrieb (161) jeweils zumindest einen kommunikativ mit dem Computergerät (140) verbundenen Servomotor umfassen.

8. Siebdruckmaschine (100) nach Anspruch 7,
**dadurch gekennzeichnet, dass**
a) der zumindest einen Servomotor zumindest einen kommunikativ mit dem Computergerät (140) verbundenen Absolutwertgeber umfasst,
b) wobei der Absolutwertgeber bevorzugt eine Ortsauflösung einer Rakelposition der Rakel (110) oder einer Plattenposition der Druckplatte (160) entlang der X-Achse (X) von 0,1 µm bis 100 µm, besonders bevorzugt von 1 µm bis 10 µm, bereitstellt.

9. Siebdruckmaschine (100) nach einem der Ansprüche 7 bis 8,
**dadurch gekennzeichnet, dass** das Sensorsystem (150) eine Kamera (151) zur Aufnahme eines Bildes des Druckbilds, bevorzugt mit einer Ortsauflösung entlang der X-Achse (X) von 0,1 µm bis 100 µm, besonders bevorzugt von 1 µm bis 10 µm, umfasst.

10. Siebdruckmaschine (100) nach einem der Ansprüche 7 bis 9,
**dadurch gekennzeichnet, dass** die Druckplatte (160) eine kommunikativ mit dem Computergerät (140) verbundene Vakuum-Fixiervorrichtung (162) zum Ansaugen eines mit der Siebdruckmaschine (100) zu bedruckenden Substrats an die Druckplatte (160) umfasst.

## Claims

1. Computer-implemented method (200) for controlling a screen printing machine (100) with
a) at least one electric squeegee drive (130) for translating a squeegee (110) of the screen printing machine (100) relative to a screen (120) of the screen printing machine (100) at least along an X-axis (X) which is parallel to the screen (120),
b) at least one electric plate drive (161) for shifting of a printing plate (160) of the screen printing machine (100) at least along the X-axis (X) relative to the screen (120) and
c) at least one computer device (140) communicatively connected to the squeegee drive (130) and the plate drive (161),
comprising the following steps:
d) fixing (201) a substrate on the printing plate (160),
e) automated printing (210) of a printing paste (DP) with the squeegee (110) through the screen (120) for producing a print image on the substrate after the fixing (201),
e1) wherein the computer device (140) pulls the squeegee (110) with the squeegee drive (130) with a squeegee speed (v_{P}) along the X-axis (X) over the screen (120),
f) removing the substrate from the screen (120) after the printing (210),
g) determining (220) at least one deviation (Δx) of an actual dimension (xᵢ) of the print image along the X-axis (X) from a corresponding target dimension (xₛ) of the print image after the printing (210) and after the removing of the substrate from the screen (120),
h) calculating (222) at least one plate speed (v_{P}) of the printing plate (160) for compensating the deviation (Δx) by the computer device (140) and
i) shifting (230) of the printing plate (160) with the plate drive (161) with the at least one plate speed (v_{P}) along the X-axis (X) by the computer device (140) during a further printing operation (210),
j) wherein the determining (220) of the deviation (Δx) of the actual dimension (xᵢ) of the print image from the corresponding target dimension (xₛ) comprises the following steps:
j1) identifying (221) the actual dimension (xᵢ) of the print image along the X-axis (X) after the printing (210) automatically by the computer device (140) with the aid of a sensor system (150) of the screen printing machine (100) which is communicatively connected with the computer device (140) and
j2) calculating (222) the deviation (Δx) as a difference (xᵢ - xₛ) between the target dimension (xₛ) and the actual dimension (xᵢ).

2. Method according to claim 1,
**characterized in that**
a) the computer device (140) pulls the squeegee (110) over the screen (120) during the printing (210) with at least one servomotor of the squeegee drive (130), and
b) the computer device (140) shifts the printing plate (160) during the shifting (230) with at least one servomotor of the plate drive (161),
c) wherein the computer device (140) preferably measures a speed of at least one of the servomotors with an absolute value transmitter of the servomotor,
d) wherein the absolute value transmitter particularly preferably provides a spatial resolution of a squeegee position of the squeegee (110) or a plate position of the printing plate (160) along the X-axis (X) of 0.1 µm to 100 µm, particularly preferably of 1 µm to 10 µm.

3. Method according to one any of the claims 1 to 2,
**characterized in that**
the fixing (201) of the substrate on the printing plate (160) includes an automatic sucking of the substrate to the printing plate (160) by means of a vacuum fixing device (162) of the printing plate (160) which is controlled by the computer device (140).

4. Method according to any one of the claims 1 to 3,
**characterized in that**
a) the identifying (221) of the actual dimension (xᵢ) of the print image along the X-axis takes place at multiple positions of the print image along the X-axis which are spaced apart from one another,
b) wherein the calculating (222) of the deviation (Δx) results in a deviation (Δx) which is dependent on a position along the X-axis,
c) wherein the calculating (222) of the plate speed (v_{P}) results in a plate speed (v_{P}) which is dependent on the position along the X-axis.

5. Method according to any one of the claims 1 to 4,
**characterized in that**
a) wherein the identifying (221) preferably comprises applying an image recognition algorithm to an image of the print image captured by a camera (151) of the sensor system (150),
b) wherein the image particularly preferably has a spatial resolution of the print image along the X-axis (X) of 0.1 µm to 100 µm, most preferably from 1 µm to 10 µm.

6. Method according to any one of the claims 1 to 5,
**characterized in that**
a) the calculating (222) results in a plate speed (v_{P}) which is same directioned with the squeegee speed (v_{R}) if the deviation (Δx) is positive, wherein
b) the calculating (222) preferably results in a plate speed (v_{P}) which corresponds to a product of the squeegee speed (v_{R}) with the deviation (Δx) divided by the target dimension (xₛ).

7. A computer-controlled screen printing machine (100) for performing a method according to any one of the claims 1 to 6, comprising
a) at least one electric squeegee drive (130) for translating a squeegee (110) of the screen printing machine (100) relative to a screen (120) of the screen printing machine (100) at least along an X-axis (X) which is parallel to the screen (120),
b) at least one electric plate drive (161) for translating a printing plate (160) of the screen printing machine (100) at least along the X-axis (X) relative to the screen (120) and
c) at least one computer device (140) communicatively connected to the squeegee drive (130) and the plate drive (161) and
d) a sensor system (150) communicatively connected to the computer device (140) for automatically identifying (221) an actual dimension (xᵢ) of a print image printed with the screen printing machine (100) along the X-axis (X),
e) wherein the squeegee drive (130) and the plate drive (161) respectively comprise at least one servomotor communicatively connected to the computer device (140).

8. Screen printing machine (100) according to claim 7,
**characterized in that**
a) the at least one servomotor comprises at least one absolute value transmitter communicatively connected to the computer device (140),
b) wherein the absolute value transmitter preferably provides a spatial resolution of a squeegee position of the squeegee (110) or a plate position of the printing plate (160) along the X-axis (X) of 0.1 µm to 100 µm, particularly preferably of 1 µm to 10 µm.

9. Screen printing machine (100) according to one of claims 7 to 8,
**characterized in that**
the sensor system (150) comprises a camera (151) for capturing an image of the print image, preferably with a spatial resolution along the X-axis (X) of 0.1 µm to 100 µm, particularly preferably of 1 µm to 10 µm.

10. Screen printing machine (100) according to one of claims 7 to 9,
**characterized in that**
the printing plate (160) comprises a vacuum fixing device (162) communicatively connected to the computer device (140) for sucking a substrate to be printed with the screen printing machine (100) to the printing plate (160).

## Revendications

1. Procédé mise en oeuvre par ordinateur (200) permettant de commander une machine d'impression sérigraphique (100) comprenant
a) au moins un entraînement de racloir électrique (130) pour la translation d'un racloir (110) de la machine d'impression sérigraphique (100) par rapport à un pochoir (120) de la machine d'impression sérigraphique (100) au moins le long d'un axe X (X) parallèle au pochoir (120),
b) au moins un entraînement de plaque électrique (161) pour le déplacement d'une plaque d'impression (160) de la machine d'impression sérigraphique (100) au moins le long de l'axe X (X) par rapport au pochoir (120) et
c) au moins un appareil informatique (140) relié en communication à l'entraînement de racloir (130) et à l'entraînement de plaque (161),
d) fixation (201) d'un substrat sur la plaque d'impression (160),
e) impression automatisée (210) d'une pâte d'impression (DP) à l'aide du racloir (110) à travers le pochoir (120) pour la réalisation d'une image d'impression sur le substrat après la fixation (201),
e1) dans lequel l'appareil informatique (140) tire le racloir (110) avec l'entraînement de racloir (130) à une vitesse de racloir (v_{R}) au-dessus du pochoir (120) le long de l'axe X (X),
f) éloignement du substrat par rapport au pochoir (120) après l'impression (210),
g) détermination (220) d'au moins un écart (Δx) d'une dimension effective (xᵢ) de l'image d'impression le long de l'axe X (X) par rapport à une dimension théorique (xₛ) correspondante de l'image d'impression après l'impression (210) et après l'éloignement du substrat par rapport au pochoir (120),
h) calcul (222) d'au moins une vitesse de plaque (v_{P}) de la plaque d'impression (160) pour la compensation de l'écart (Δx) par l'appareil informatique (140) et
i) déplacement (230) de la plaque d'impression (160) avec l'entraînement de plaque (161) à l'au moins une vitesse de plaque (v_{P}) le long de l'axe X (X) par l'appareil informatique (140) pendant une autre impression (210),
j) dans lequel la détermination (220) de l'écart (Δx) de la dimension effective (xᵢ) de l'image d'impression par rapport à la dimension théorique (xₛ) correspondante comporte les étapes suivantes :
j1) détermination (221) de la dimension effective (xᵢ) de l'image d'impression le long de l'axe X (X) automatiquement par l'appareil informatique (140) à l'aide d'un système de capteur (150) de la machine d'impression sérigraphique (100) relié en communication à l'appareil informatique (140) après l'impression (210) et
j2) calcul (222) de l'écart (Δx) en tant que différence (xᵢ - xₛ) de la dimension théorique (xₛ) par rapport à la dimension effective (xᵢ).

2. Procédé selon la revendication 1,
**caractérisé en ce que**
a) l'appareil informatique (140) tire le racloir (110) pendant l'impression (210) à l'aide d'au moins un servomoteur de l'entraînement de racloir (130) au-dessus du pochoir (120), et
b) l'appareil informatique (140) déplace la plaque d'impression (160) pendant le déplacement (230) à l'aide d'au moins un servomoteur de l'entraînement de plaque (161),
c) dans lequel l'appareil informatique (140) mesure de préférence une vitesse de l'un au moins des servomoteurs à l'aide d'un indicateur de valeur absolue du servomoteur,
d) dans lequel l'indicateur de valeur absolue fournit de façon particulièrement préférentielle une résolution spatiale de 0,1 µm à 100 µm, de façon particulièrement préférentielle de 1 µm à 10 µm, d'une position de racloir du racloir (110) ou d'une position de plaque de la plaque d'impression (160) le long de l'axe X (X).

3. Procédé selon l'une des revendications 1 à 2,
**caractérisé en ce que**
la fixation (201) du substrat sur la plaque d'impression (160) comporte une aspiration automatique du substrat sur la plaque d'impression (160) à l'aide d'un dispositif de fixation sous vide (162) de la plaque d'impression (160) commandé par l'appareil informatique (140).

4. Procédé selon l'une des revendications 1 à 3,
**caractérisé en ce que**
a) la détermination (221) de la dimension effective (xᵢ) de l'image d'impression le long de l'axe X est effectuée à plusieurs positions de l'image d'impression espacées les unes des autres le long de l'axe X,
b) dans lequel le calcul (222) de l'écart (Δx) donne un écart (Δx) dépendant d'une position le long de l'axe X,
c) dans lequel le calcul (222) de la vitesse de plaque (v_{P}) donne une vitesse de plaque (v_{P}) dépendante de la position le long de l'axe X.

5. Procédé selon l'une des revendications 1 à 4,
**caractérisé en ce que**
a) dans lequel la détermination (221) comporte de préférence une application d'un algorithme de reconnaissance d'image sur une image de l'image d'impression capturée à l'aide d'une caméra (151) du système de capteur (150),
b) dans lequel l'image présente de façon particulièrement préférentielle une résolution spatiale de 0,1 µm à 100 µm, le plus préférentiellement de 1 µm à 10 µm, de l'image d'impression le long de l'axe X (X).

6. Procédé selon l'une des revendications 1 à 5,
**caractérisé en ce que**
a) le calcul (222) donne une vitesse de plaque (v_{P}) alignée sur la vitesse de racloir (v_{R}) lorsque l'écart (Δx) est positif, dans lequel
b) le calcul (222) donne de préférence une vitesse de plaque (v_{P}) correspondant à un produit de la vitesse de racloir (v_{R}) et de l'écart (Δx) divisé par la dimension théorique (xₛ).

7. Machine d'impression sérigraphique (100) commandée par ordinateur pour la mise en oeuvre d'un procédé selon l'une des revendications 1 à 6, comportant
a) au moins un entraînement de racloir électrique (130) pour la translation d'un racloir (110) de la machine d'impression sérigraphique (100) par rapport à un pochoir (120) de la machine d'impression sérigraphique (100) au moins le long d'un axe X (X) parallèle au pochoir (120),
b) au moins un entraînement de plaque électrique (161) pour la translation d'une plaque d'impression (160) de la machine d'impression sérigraphique (100) au moins le long de l'axe X (X) par rapport au pochoir (120) et
c) au moins un appareil informatique (140) relié en communication à l'entraînement de racloir (130) et à l'entraînement de plaque (161) et
d) un système de capteur (150) relié en communication à l'appareil informatique (140) pour la détermination automatique (221) d'une dimension effective (xᵢ) d'une image d'impression imprimée à l'aide de la machine d'impression sérigraphique (100) le long de l'axe X (X),
e) dans lequel l'entraînement de racloir (130) et l'entraînement de plaque (161) comportent respectivement au moins un servomoteur relié en communication à l'appareil informatique (140).

8. Machine d'impression sérigraphique (100) selon la revendication 7,
**caractérisée en ce que**
a) l'au moins un servomoteur comporte au moins un indicateur de valeur absolue relié en communication à l'appareil informatique (140),
b) dans lequel l'indicateur de valeur absolue fournit de préférence une résolution spatiale de 0,1 µm à 100 µm, de façon particulièrement préférentielle de 1 µm à 10 µm, d'une position de racloir du racloir (110) ou d'une position de plaque de la plaque d'impression (160) le long de l'axe X (X).

9. Machine d'impression sérigraphique (100) selon l'une des revendications 7 à 8,
**caractérisée en ce que**
le système de capteur (150) comporte une caméra (151) destinée à capturer une image de l'image d'impression, de préférence avec une résolution spatiale de 0,1 µm à 100 µm, de façon particulièrement préférentielle de 1 µm à 10 µm le long de l'axe X (X).

10. Machine d'impression sérigraphique (100) selon l'une des revendications 7 à 9,
**caractérisée en ce que**
la plaque d'impression (160) comporte un dispositif de fixation sous vide (162) relié en communication à l'appareil informatique (140) pour l'aspiration d'un substrat à imprimer à l'aide de la machine d'impression sérigraphique (100) sur la plaque d'impression (160).
